(19) Europäisches Patentamt
European Patent Office
Office européen des brevets

(11) Publication number: 0 307 752 B1

(12) # EUROPEAN PATENT SPECIFICATION

(45) Date of publication of patent specification: 22.02.95

(51) Int. Cl.6: C08F 12/14, G03F 7/022

(21) Application number: 88114475.2

(22) Date of filing: 05.09.88

(54) **Poly(3-mono- and 3,5-disubstituted-4-acetoxystyrenes and 4-hydroxy-styrenes)and their use.**

(30) Priority: 16.09.87 US 97815
02.08.88 US 226261
02.08.88 US 226259

(43) Date of publication of application:
22.03.89 Bulletin 89/12

(45) Publication of the grant of the patent:
22.02.95 Bulletin 95/08

(84) Designated Contracting States:
CH DE GB LI

(56) References cited:
EP-A- 0 240 843
EP-A- 0 260 104
US-A- 4 221 700
US-A- 4 543 397
US-A- 4 565 846
US-A- 4 600 683

(73) Proprietor: HOECHST AKTIENGESELLSCHAFT

D-65926 Frankfurt (DE)

Proprietor: HOECHST CELANESE CORPORATION
Route 202-206 North
Somerville, N.J. 08876 (US)

(72) Inventor: Vicari, Richard, Dipl.-Chem.
25 Hickory Place, Apt. H1
Chatham Tap, N.J. 07929 (US)
Inventor: Gordon, Douglas J., Dipl.-Chem.
3706 Beauregard
Corpus Christi
Texas 78415 (US)
Inventor: Rupp, Raymond W., Dipl.-Chem.
105 Lakewater
Court Greer
S. Carolina 29651 (US)
Inventor: Dammel, Ralph, Dr. Dipl.-Chem.
Eibenweg 39
D-6500 Mainz-Bretzenheim (DE)
Inventor: Dössel, Karl-Friedrich, Dr. Dipl.-Chem.
Fritz-Kalle-Strasse 8
D-6200 Wiesbaden (DE)
Inventor: Lingnau, Jürgen, Dr. Dipl.-Chem.
Karolingerstrasse 10
D-6500 Mainz-Laubenheim (DE)
Inventor: Lockard, James P., Dipl.-Chem.
RD. No. 1, 239-J, Blossom Drive
Basking Ridge, N.J. 07920 (US)
Inventor: Aslam, Mohammed, Dipl.-Chem.
772 Diamond Ridge
Corpus Christi
Texas 78413 (US)

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).



Rank Xerox (UK) Business Services
(3.10/3.09/3.3.3)

Inventor: **Ray, Wilson B., Dipl.-Chem.**
**1115 S. Kathleen**
**Begville**
**Texas 78102 (US)**
Inventor: **Davenport, Kenneth G., Dipl.-Chem.**
**Hölderlinstrasse 8**
**D-6238 Hofheim (DE)**

(74) Representative: **Meyer-Dulheuer, Karl-Hermann, Dr. et al**
**Hoechst AG,**
**Werk Kalle-Albert,**
**Zentrale Patentabteilung KA**
**D-65174 Wiesbaden (DE)**

## Description

The present invention relates to novel polymers and copolymers which are derivatives of 3-mono- and 3,5-di-substituted-4-acetoxy- and -4-hydroxystyrenes, as well as the production and use thereof. The production of 3-mono and 3,5-disubstituted-4-acetoxy- and -4-hydroxystyrene monomers and polymers are the subject of the EP-A 0 307 751 and 0 353 339. In a preferred embodiment the invention relates to poly-(3-mono- and 3,5-dihalogenated 4-acetoxy- and 4-hydroxystyrenes) and their copolymers.

It is well known in the art to produce positive photoresist formulations such as those described in US-A-3,666,475, 4,115,128 and 4,173,470. These include alkali-soluble phenol-formaldehyde Novolak resins together with light-sensitive materials, usually a substituted napthoquinone diazide compound. The resins and sensitizers are dissolved in an organic solvent or mixture of solvents and are applied as a thin film or coating to a substrate suitable for the particular application desired. Polyvinyl phenols are taught in US-A-3,869,292 and 4,439,516.

Alpha acetoxystyrene and beta acetoxystyrenes are described in US-A- 4,144,063 and acetoxymethylstyrene is taught in US-A- 3,963,495. US-A- 4,075,237 describes 1,4-dimethyl-2-hydroxystyrene and 3,5-dibromo-4-hydroxystyrene.

US-A- 4,565,846 teaches the use of poly(3,5-dimethyl-4-hydroxystyrene), poly(p-hydroxy-styrene bromide) and poly(3-methoxy-4-hydroxy-styrene) having an average molecular weight of 1,000 to 30,000 as a starting material in the production of polyorganosiloxane-base copolymers of the crosslinked type.

JP-B 84/023747 describes anti-static compounds employing poly(acetoxymethylstyrene).

US-A- 4,221,700 describes a stabilized synthetic polymer composition. As a stabilizer the composition contains an alkylated poly(4-hydroxy-styrene). The $(C_1\text{-}C_{18})$alkyl substituents are located in the ortho-position to the hydroxyl group of the 4-hydroxy-styrene units.

US-A- 4,600,683 describes a photoresist composition containing crosslinked polyalkenyl phenols. In the monomeric units $(C_1\text{-}C_{18})$alkyl groups in the ortho-position to the hydroxyl group may be present.

In the US-A- 4,543,397 polyfunctional cationically polymerizable styryloxy compounds obtained from 4-hydroxy-3-methoxy-styrene are disclosed.

US-A- 4,517,028, 4,460,770 and 4,539,051 describe dimethyl vinyl phenol. The resin component of these photoresist formulations is soluble in aqueous alkaline solutions, but the naphthoquinone sensitizer acts as a dissolution rate inhibitor with respect to the resin. Upon exposure of selected areas of the coated substrate to actinic radiation, however, the sensitizer undergoes a radiation induced structural transformation and the exposed areas of the coating are rendered more soluble than the unexposed areas. This difference in solubility rates causes the exposed areas of the photoresist coating to be dissolved when the substrate is immersed in an alkaline developing solution while the unexposed areas are largely unaffected, thus producing a positive relief pattern on the substrate.

In most instances, the exposed and developed substrate will be subjected to treatment by a substrate etchant solution. The photoresist coating protects the coated areas of the substrate from the etchant and thus the etchant is only able to etch the uncoated areas of the substrate, which in the case of a positive photoresist, correponds to the areas that were exposed to actinic radiation. Thus, an etched pattern can be created on the substrate which corresponds to the pattern on the mask, stencil, template, etc., that was used to create selective exposure patterns on the coated substrate prior to development.

The relief pattern of the photoresist on the substrate produced by the method described above is useful for various applications including as an exposure mask or a pattern such as is employed in the manufacture of miniaturized integrated electronic components. The properties of a photoresist composition which are important in commercial practice include the photospeed of the resist, development contrast, resist resolution, and resist adhesion. Resist resolution refers to the capacity of a resist system to reproduce the smallest equally spaced line pairs and intervening spaces of a mask which is utilized during exposure with a high degree of image edge acuity in the developed exposed spaces.

In many industrial applications, particularly in the manufacture of miniaturized electronic components, a photoresist is required to provide a high degree of resolution for very small line and space widths (of the order of one µm or less).

The ability of a resist to reproduce very small dimensions, on the order of a micron or less, is extremely important in the production of large scale integrated circuits on silicon chips and similar components. Circuit density on such a chip can only be increased, assuming photolithography techniques are utilized, by increasing the resolution capabilities of the resist.

Photoresists are generally categorized as being either positive-working or negative-working. In a negative-working resist composition, the imagewise light struck areas harden and form the image areas of the resist after removal of the unexposed areas with a developer. In a positive-working resist the exposed

areas are the non-image areas. The light struck parts are rendered soluble in aqueous alkali developers. While negative resists are the most widely used for industrial production of printed circuit boards, positive resists are capable of much finer resolution and smaller imaging geometries. Therefore, positive resists are the choice for the manufacture of densely packed integrated circuits. Hence the invention provides novel polymers and photographic compositions employing these polymers. In one important aspect of the invention, it has been found that photoresists which employ the aforesaid polymer as a binder resin show comparable development and dissolution properties to phenol formaldehyde novolak resins but an advantageously lower dissolution rate than polyvinyl phenols which are also known for this purpose. Polyvinyl phenols have the disadvantage of faster dissolution, which makes image differentiation more difficult to attain. However, they are capable of withstanding much higher processing temperatures, on the order of about 200 °C, than the novolaks. The preferred polymers and copolymers of this invention demonstrate a dissolution rate comparable to the novolaks and can withstand processing temperatures comparable to the polyvinyl phenols. It is also an improvement over poly(4-hydroxy styrene) which typically can only be produced in a low molecular weight, off-color, impure form.

Brominated poly(4-hydroxy)styrenes are also known. According to DE-A 38 21 585 these can be used in corresponding photoresists as radiation-sensitive compounds, i.e. compounds which form acids under the influence of radiation. Their synthesis is accomplished by brominating poly(4-hydroxy)styrene. The resulting products may have a bromine content of up to approximately 50 wt%. However, the exact substitution pattern is not accessible with compounds prepared in this way. One of the results of this is a considerable effect on their range of application in radiation-sensitive mixtures. It has been shown that post-brominated poly(4-hydroxy)styrenes of this type (e.g. Maruzen Resin MB) have certain disadvantages as compounds releasing acid under the action of actinic radiation in combination with materials cleavable by these acids, as described in DE-A 38 21 585.

One of these is the overly high decomposition rate of the radiation-sensitive mixture containing these polymers, which make image differentiation impossible after exposure and development when the radiation-sensitive mixture has been in storage for only one week. It is suspected that when the polymers are brominated not only are pure products substituted in the ring produced, but some aliphatic chains are brominated as well, or bromine is present merely absorbed in polymers, so that hydrogen halide occurs not only by irradiation in the zones irradiated according to the image (cleaving of the ring-substituted halogens to make hydrogen halides) but acids are also released thermally in the unexposed zones.

This presents the goal of preparing polymers or copolymers able to form an acid under the influence of radiation and in a mixture with the other components of a radiation-sensitive mixture and not having the above-described disadvantages of the prior art.

The invention provides Homo- and copolymers of 3-mono- and 3,5-disubstituted 4-acetoxy- and 4-hydroxy-styrenes having a molecular weight in the range of from 1,000 to 800,000, wherein said substituents in the 3- or 3,5-position independently are ($C_1$-$C_{10}$)alkyl, ($C_1$-$C_{10}$)alkoxy, primary or secondary amino, halogen (Cl, Br, I), $NO_2$, or $SO_3H$, wherein homo- and copolymers of 4-hydroxy-styrene which is 3-monosubstituted with ($C_1$-$C_{10}$)alkoxy or which is 3-mono- or 3,5-disubstituted with ($C_1$-$C_{10}$)alkyl are excluded.

Preferred are homopolymers, wherein the substituents in the 3- or 3,5-positions independently are ($C_1$-$C_{10}$)alkyl, in particular methyl, ($C_1$-$C_{10}$)alkoxy, primary or secondary amino, or halogen.

Especially preferred are homo- and copolymers, wherein the substituents in the positions 3 or 3 and 5 are ($C_1$-$C_{10}$)alkyl or halogen, said homo- and copolymers containing units of the general formula I

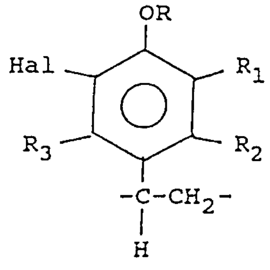

(I)

wherein

| | |
|---|---|
| R | is hydrogen or acetyl, |
| Hal | is chlorine or bromine, |
| $R_1$ | is hydrogen, ($C_1$-$C_{10}$)alkyl, or halogen; and |

$R_2$ and $R_3$ are hydrogen.

Particularly preferred are homo- and copolymers, wherein

R is hydrogen,

Hal is bromine and

$R_1$ is $(C_1-C_3)$alkyl; and

$R_2$ and $R_3$ are hydrogen.

The invention provides further copolymers of general formula III

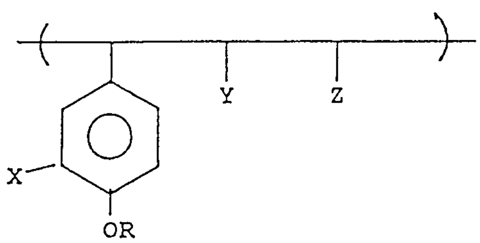

(III)

wherein

R is hydrogen or acetyl, in particular acetyl,

X is $(C_1-C_{10})$alkyl, $(C_1-C_{10})$alkoxy, primary or secondary amino, Br, I, Cl, $NO_2$ or $SO_3H$, and

Y is 4-acetoxy- or 4-hydroxy-styrene, styrene, an acrylate or methacrylate, 3,5-di-X-substituted 4-acetoxy- or 4-hydroxy-styrene, maleic anhydride or N-substituted maleimides wherein the N-substituents are selected from the group consisting of aliphatic, cycloaliphatic and heterocyclic groups and

Z is absent or is selected from 4-acetoxy- or 4-hydroxy-styrene, styrene, an acrylate or methacrylate, 3,5-di-X-substituted 4-acetoxy- or 4-hydroxy-styrene, maleic anhydride or N-substituted maleimides wherein the N-substitution is selected from the group consisting of aliphatic, cycloaliphatic and heterocyclic groups; and wherein said copolymer or terpolymer has an average molecular weight in the range of from 1,000 to 800,000.

Further, a preferred embodiment of the invention is a copolymer of general formula IV

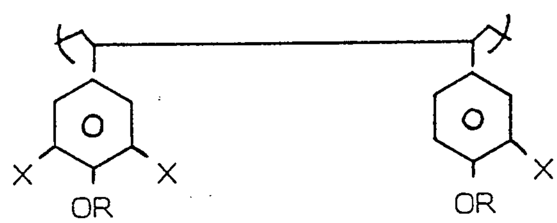

IV

wherein

R is hydrogen or acetyl, in particular hydrogen; and

X is independently $C_1$ to $C_{10}$ alkyl, Br, I, Cl, $NO_2$ or $SO_3H$; and wherein the copolymer has an average molecular weight in the range of from 1,000 to 800,000.

In particular, the copolymers have an average molecular weight in the range of from 5,000 to 15,000.

These polymers and copolymers have been found to be useful on various applications such as adhesives, coatings and binder resins for photoresists.

These polymers or copolymers have high storage stability in radiation-sensitive mixtures.

The polymers or copolymers which have either 3,5-dibromo or 3,5-dichloro substituted units have a very high dissolution rate.

On the other hand, polymers or copolymers which have 3-bromo or 3-chloro-5-alkyl substituted units have better image differentiation and a higher residence time in the developer.

The invention further provides a photosensitive composition which comprises a polymer according to the invention and an o-quinone diazide photosensitizer; and a suitable solvent; wherein said polymer is present in sufficient amount to serve as a binder for the composition, and said diazide is present in sufficient amount to provide image differentiation when the composition is coated on a substrate and

imagewise exposed to actinic radiation; and said solvent is present in sufficient amount to form a homogeneous solution of the composition components.

A photographic element is prepared by coating this composition onto a suitable support. A process for forming a photographic image comprises coating the above photographic composition on a substrate, drying the composition until it is substantially non-tacky; imagewise exposing the composition to sufficient actinic, electron beam or x-ray radiation to provide an imagewise differentiation, and removing the non-image portions of said composition with a suitable developer.

The process for the production of 3-mono or 3,5-disubstituted-4-acetoxy- and -4-hydroxystyrene is shown below. To produce 3,5-dimethyl-4-acetoxystyrene monomer, one begins with commercially available 2,6-dimethyl phenol and esterifies it with acetic anhydride to produce 2,6-dimethyl phenyl acetate. Then, via a Friedel-Crafts catalysis or Fries rearrangement this is converted to 3,5-dimethyl-4-hydroxy acetophenone. The 3,5-dimethyl-4-hydroxy acetophenone is then esterified with acetic anhydride. The ester is then hydrogenated to form 1-(3',5'-dimethyl-4'-acetoxyphenyl) ethanol. This is then dehydrated with an acid to form 3,5-dimethyl-4-acetoxystyrene monomer. Optionally, a hydrolysis can be added.

A typical reaction sequence may be described schematically as follows:

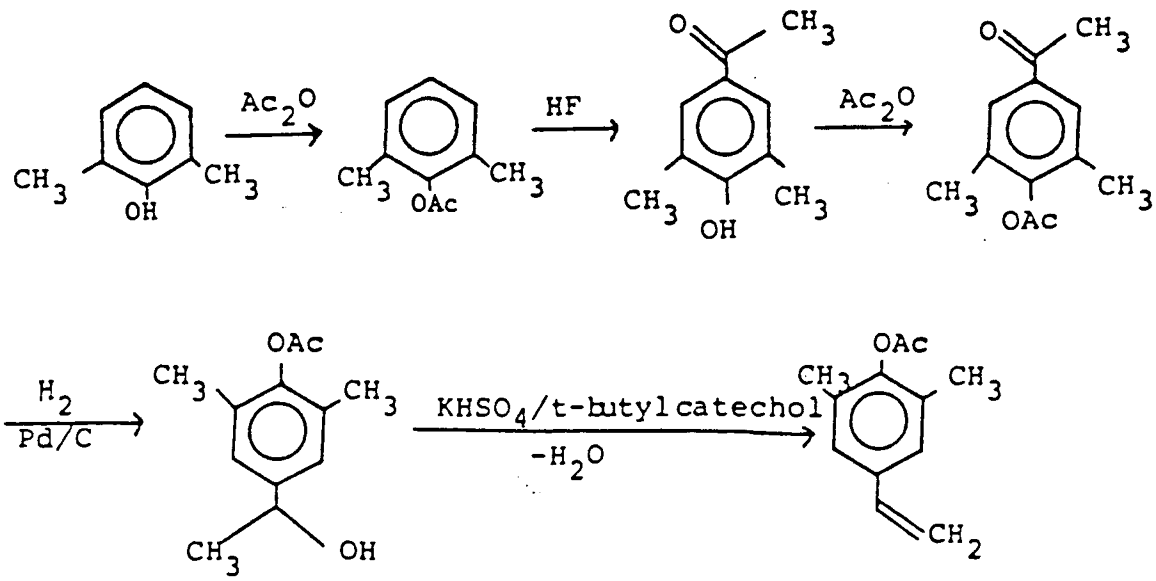


The 3-mono- and 3,5-disubstituted-4-acetoxystyrene monomer is then polymerized by a free radical initiation process to produce poly(3-mono- or 3,5-disubstituted-4-acetoxystyrenes) such that it has a molecular weight in the range of from 1,000 to 800,000, preferably 1,000 to 50,000 or more preferably 5,000 to 15,000. This intermediate is then hydrolyzed with a base or an acid to form poly(3-mono- or 3,5-disubstituted-4-hydroxystyrenes) such that it also has a molecular weight range of from 1,000 to 500,000.

One preferred free radical initiation is azoisobutyronitrile. Other azo type initiators are also suitable. Still others non-exclusively include peroxides such as benzoyl peroxide, and di-t-butyl peroxide. It is predicted that essentially any free radical initiation system will serve in the same fashion.

One preferred hydrolyzing agent is tetramethyl ammoniumhydroxide. Other hydrolyzing agents non-exclusively include aqueous $NH_3$, NaOH and KOH.

The afore-mentioned 3-substituted-4-acetoxy- or 4-hydroxystyrenes may also be co- or terpolymerized under the foregoing polymerization conditions in the presence of one or more additional monomers which may be 4-acetoxystyrene, 3,5-disubstituted-4-acetoxy- or 4-hydroxystyrene, maleic anhydride, maleimides, styrene, methacrylate, methylmethacrylate and butyl acrylate.

The 3-substituted-4-acetoxystyrene may also be copolymerized with 3,5-disubstituted-4-acetoxystyrene and then hydrolyzed with an acid or base to form poly(3-substituted-4-hydroxystyrene / 3,5-disubstituted-4-hydroxystyrene).

The preparation of the monomers as starting materials for polymers according to the present invention usually starts with a) halogenation of a 4-hydroxyacetophenone of general formula

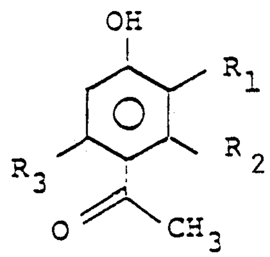

wherein

$R_1$ is hydrogen or alkyl, in particular ($C_1$-$C_{10}$) alkyl, and

$R_2$ and $R_3$ are independently hydrogen, alkyl, alkoxy, or halogen,

whereby

$R_1$ and $R_2$ may also be combined to form a cycloaliphatic ring, consisting in particular of 6 to 12 members, in particular carbon atoms, followed by

b) esterification (protection) of the hydroxyl function to form a halogenated 4-acetoxyacetophenon derivative,

c) reduction of the ketone function to a hydroxyl function,

d) dehydration to form 3-mono or 3,5-disubstituted 4-acetoxystyrene; and where appropriate

e) hydrolysis of the protective group to form the 3-mono or 3,5-disubstituted-4-hydroxystyrene.

In polymerization of the monomers on which general formula I is based, at least 10 mole-% of the monomeric compounds which come under this formula are used. Homopolymerization, construed also to comprise polymerization of different monomers coming under formula I, is particularly preferred.

In addition, copolymers containing at least 10 mole-% of the units which come under general formula I are particularly preferred.

All monomers which are polymerizable by radical or ionic polymerization are useful as monomers suitable for copolymerization with the monomers on which the formula I is based. These include: styrene, 4-acetoxystyrene, 4-hydroxystyrene, 3,5-disubstituted, particularly dialkylated but not halogenated, acetoxystyrene or hydroxystyrene, acrylates, methacrylates, in particular butyl acrylate and methyl methacrylate, maleic anhydride and its derivatives, particularly maleic anhydride, etc. However, homopolymers are particularly preferred.

Homopolymerization or copolymerization leads to polymers or copolymers with molecular weights (MW) of 1,000 to 500,000, preferably from 5,000 to 300,000, particularly preferably from 5,000 to 35,000.

The non-uniformity (U) in these polymers is particularly 0.5 to 1.5. It is defined as

$$U = \frac{Mw}{Mn} - 1$$

The polymerization as such can be either radical or ionic, particularly cationic. Radical polymerization started by initiators such as azobisisobutyronitrile is particularly preferred. In addition, peroxides such as benzoyl peroxide and di-t-butyl peroxide are worthy of mention.

Polymerization can be either solution polymerization in which the monomers are dissolved in a solvent, or in bulk.

According to general formula I, the styrene derivatives which still have protective groups (4-acetoxystyrene derivatives) as well as already-hydrolyzed monomers (4-hydroxystyrene derivatives) are polymerized, so that both protected and unprotected monomeric units can be contained in the polymers. The hydrolysis optionally carried out at the monomer stage to protect the 4-hydroxy function can be repeated at the polymer stage. Both hydrolysis options offer the opportunity of matching the properties of the polymers produced to industrial requirements.

One preferred hydrolyzing agent is tetramethyl ammonium hydroxide. Other hydrolyzing agents non-exclusively include aqueous $NH_3$, NaOH and KOH.

Hydrolysis at the polymer stage can be carried out in acids or in alkalis. A gentler variant -hydrazinolysis followed by acid hydrolysis - is also possible.

Possible hydrolyzing agents are HCl ad $H_2SO_4$; basic hydrolysis is usually done with $NH_3$, NaOH, KOH and also with tetramethylammonium hydroxide.

In the production of the photosensitive composition and photographic element of this invention, one blends the above produced binding resins with a sensitzer such as an o-quinone diazide photosensitizer (e.g. as disclosed in claim 9) and a suitable solvent until a homogeneous solution is formed. The solution is then coated on a suitable substrate and dried until it is non-tacky.

The use of o-quinone diazides is well known to the skilled artisan as demonstrated by Light Sensitive Systems, Kosar, J.; John Wiley & Sons, New York, 1965 in Chapter 7.4. These sensitizers which comprise a component of the present resist compositions of the present invention are preferably selected from the group of substituted naphthoquinone diazide sensitizers which are conventionally used in the art in photoresist formulations. Such sensitizing compounds are disclosed, for example, in US-A- 2,797,213; 3,106,465; 3,148,983; 3,130,047; 3,201,329; 3,785,825; and 3,802,885.

The photosensitzer is preferably a 1,2-quinone diazide-4 or 5- sulfonic acid ester of a phenolic derivative. It presently appears that the number of fused rings is not important for this invention but the position of the sulfonyl group is important. That is, one may use benzoquinones, naphthoquinones or anthraquinones as long as the oxygen is in the 1 position, diazo is in the 2 position and the sulfonyl group is in the 4 or 5 position. Likewise the phenolic member to which it is attached does not appear to be important. For example it can be a cumylphenol derivative as taught in US-A 3,640,992 or it can be a mono-, di-, or trihydroxyphenyl alkyl ketone or benzophenone as shown in US-A 4,499,171.

Useful photosensitizers include 1,2-naphthoquinone-2-diazide-4-sulfonyl chloride, condensed with phenolic compounds such as hydroxy benzophenones (especially trihydroxybenzophenone and more particularly 2,3,4-trihydroxybenzophenone) or 2,3,4-trihydroxyphenyl pentyl ketone; 1,2-naphthoquinone-2-diazide-4-sulfonic acid trisester of other alkyl phenones; 2,3,4-trihydroxy-3'-methoxy-benzophenone-1,2-naphthoquinone-2-diazide-4-sulfonic acid trisester; 2,3,4-trihydroxy-3'-methylbensophenone-1,2-naphthoquinone-2-diazide-4-sulfonic acid trisester; and 2,3,4-trihydroxy-benzophenone-1,2-naphthoquinone diazide-4-sulfonic acid trisester.

In the photosensitive composition the ratio by weight of the homo- or copolymer to the light-sensitive compound is in the range of from 1:1 to 20:1.

The invention also provides a positive-working radiation-sensitive mixture, which comprises a radiation-sensitive compound forming an acid (starter) as well as a compound cleavable by acid, wherein the acid-forming compound is a homo- or copolymer according to claim 3, 4 or 7.

The content of this polymeric starter in the radiation-sensitive mixture amounts to 5 to 60 wt.%. In addition to the claimed polymeric starters, monomeric and polymeric starters according to DE-A 38 21 585 can also be contained in the radiation-sensitive mixture.

However, it is preferable for the polymeric starters not to be used in the mixture with other polymeric starters and monomeric starters.

The following classes of compounds have proved to be successful as acid-cleavable materials in the radiation-sensitive mixture according to the invention:

a) those with at least one orthocarboxylic acid ester and/or carboxylic acid amide acetal group, whereby the compounds also have a polymeric nature and the aforesaid groups can appear as connecting elements in the main chain or as lateral substituents,
b) oligomeric compounds or polymeric compounds with repeating acetal groups and /or ketal groups in the main chain,
c) compounds with at least one enol ether or N-acyliminocarbonate group,
d) cyclic acetals or ketals of beta-ketoesters or beta-ketoamides,
e) compounds with silyl ether groups,
f) compounds with silylenol ether groups,
g) monoacetals or monoketals, whose aldehyde or ketone components have solubilities in the developer of between 0.1 and 100 g/l,
h) ethers based on tertiary alcohols,
i) carboxylic esters and carbonates of tertiary, allylic or benzylic alcohols.

Acid-cleavable Type a) compounds as components of radiation-sensitive mixtures are described in detail in EP-A-0 022 571 and DE-A-26 10 842; mixtures containing Type b) compounds are described in DE-C-23 06 247 and DE-C-27 18 254; Type c) compounds are described in EP-A-0 006 626 and 0 006 627; Type d) compounds are described in EP-A-0 202 196 and compounds including Type e) are described in DE-A- 3 544 165 and DE-A-3 601 264; Type f) compounds are to be found in Patent Application P 37 30 783.5, while Type g) compounds are dealt with in DE-A-37 30 785 and 37 30 787. Type h) compounds are described for example in US-A-4 603 101, Type i) compounds are described for example in US-A-4 491 628 and by J. M. Frechet et al., J. Imaging Sci., 30, 59-64 (1986).

Mixtures of the aforesaid acid-cleavable materials can also be used. However, an acid cleavable material which belongs to one of the above-listed types is preferred. Materials which belong to Types a), b), g), and i) are particularly preferred. Under Type b), the polymeric acetals deserve special mention and, of the acid-cleavable materials in Type g), particularly those whose aldehyde or ketone components have a boiling point higher than 150 °C, preferably higher than 200 °C.

Acid-cleavable materials having at least one C-O-C bond in the compound are particularly preferred.

The content of acid-cleavable material in the radiation-sensitive mixture according to the invention should be 1 to 50 wt.% and preferably 5-25 wt.%, in both cases based on the total weight of the coating layer.

The radiation-sensitive mixture according to the invention can also contain a binder insoluble in water but soluble, at least swellable, in organic solvent or alkali. Examples are primarily phenolic resins of the Novolak type such as phenol-formaldehyde resins, cresol-formaldehyde resins, their co-condensates, mixtures thereof such as phenol and cresol condensates with formaldehyde.

In addition, vinyl polymers such as polyvinyl acetals, polymethacrylates, polyacrylates, polyvinyl ethers, polyvinylpyrrolidones, and styrene polymers, possibly modified by comonomers, alone or in mixtures with others, can be used.

The following are particular examples: polymers of styrene with units of alkenylsulfonylaminocarbonyloxy polymers or cycloalkenylsulfonylaminocarbonyloxy polymers (EP-A-0 184 804) of acrylic acid, methacrylic acid, maleic acid, itaconic acid, etc. with lateral crosslinking $-CH_2OR$ groups (EP-A-0 184 044), polymers of vinyl monomers with alkenylphenol units (EP-A-0 153 682), polyvinylphenols such as a replacement for Novolak (DE-C-23 22 230), polymeric binders with lateral phenolic hydroxyl groups chains (EP-A-0 212 439 and 0 212 440), styrene-maleic anhydride copolymers (DE-A-31 30 987), polymers or unsaturated (thio)phosphinic acid iso(thio)cyanates with a polymer containing an active hydrogen DE-A-36 15 612 and 36 15 613), polymers with vinyl acetate, vinyl alcohol, and vinyl acetal units (EP-A-0 216 083) as well as polyvinyl acetals with hydroxyaldehyde units (DE-A-36 44 162).

The quantity of binder usually amounts to 1 to 90, in particular 5 to 90 wt.%, preferably 5 to 99 wt.% based on the total weight of the radiation-sensitive mixture, preferably in equal portions by weight of acid forming compound and binder. The halogen-containing starters claimed according to the invention also have binder properties. This being the case, the above-described binders may sometimes be unnecessary. As a rule, however, mixtures of the polymers (starters) according to the invention with traditional binders are used. In particular, the polymers according to the invention are mixed with Novolak resins, preferably in approximately equal proportions by weight.

Preferably the radiation-sensitive mixture according to the invention is dissolved in solvents such as ethylene glycol, glycol ethers such as glycol monomethyl ether, glycol dimethyl ether, glycol monoethyl ether or propylene glycol monoalkyl ethers, in particular propylene glycol methyl ether; aliphatic esters such as ethyl acetate, hydroxyethyl acetate, alkoxyethyl acetate, n-butyl acetate, propylene glycol monoalkyl ether acetate, in particular propylene glycol methyl ether acetate or amyl acetate; ethers such as dioxane, ketones such as methyl ethyl ketone, methyl isobutyl ketone, cyclopentanone and cyclohexanone; dimethylformamide, dimethylacetamide, hexamethylphosphoramide, N-methylpyrrolidone, butyrolactone, tetrahydrofuran, and in mixtures thereof. Glycol ethers, aliphatic esters, and ketones are particularly preferred.

The solutions produced with the components of the radiation-sensitive mixture according to the invention usually have solid contents of 5 to 60 wt.%, preferably up to 50 wt.%.

In addition, pigments, softeners, wetting agents, and flow-control agents, also polyglycols, cellulose ethers, e.g. ethylcellulose, can be added to the radiation-sensitive mixtures according to the invention to improve special requirements such as flexibility, adhesion, and gloss.

The photosensitive composition is formed by blending the ingredients in a suitable solvent composition. In the preferred embodiment the resin is preferably present in the overall composition in an amount of from 75 % to 99 % based on the weight of the solid; i.e. non-solvent parts of the composition. A more preferred range of resin would be from 80 % to 90 % and most preferably from 82 % to 85 % by weight of the solid composition parts. The diazide is preferably present in an amount ranging from 1 % to 25 % based on the weight of the solid., i.e., non-solvent parts of the composition. A more preferred range of the diazide would be from 1 % to 20 % and more preferably from 10 % to 18 % by weight of the solid composition parts.

In manufacturing the composition the resin and sensitizer are mixed with such solvents as propylene glycol alkyl ether acetate, butyl acetate, xylene, ethylene glycol monoethyl ether acetate, propylene glycol monomethyl ether and propylene glycol monomethyl ether acetate.

Additives such as colorants, dyes, anti-striation agents, plasticizers, adhesion promoters, speed enhancers, solvents and such surfactants as non-ionic surfactants may be added to the solution of resin,

sensitizer and solvent before the solution is coated onto a substrate.

Examples of dye additives that may be used together with the photoresist compositions of the present invention include Methyl Violet 2B (C.I. No. 42535), Crystal Violet (C.I. No. 42555), Malachite Green (C.I. NO. 42000), Victoria Blue B (C.I. No. 44045) and Neutral Red (C.I. NO. 50040) at one to ten percent weight levels, based on the combined weight of resin and sensitizer. The dye additives help provide increased resolution by inhibiting back scattering of light off the substrate. Anti-striation agents may be used up to a five percent weight level, based on the combined weight of resin and sensitizer. Plasticizers which may be used include, for example, phosphoric acid tri(beta-chloroethyl)-ester; stearic acid; dicamphor; polypropylene; acetal resins; phenoxy resins; and alkyd resins at one to ten percent weight levels, based on the combined weight of resin and sensitizer. The plasticizer additives improve the coating properties of the material and enable the application of a film that is smooth and of uniform thickness.

Adhesion promoters which may be used include, for example, beta(3,4-epoxy-cyclohexyl)-ethyltrimethoxysilane; p-methyl-disilanemethyl methacrylate; vinyltrichlorosilane; hexamethyldisilazane and gamma-aminopropyl triethoxysilane up to a 4 percent weight level, based on the combined weight of resin and sensitizer in silicon or silicondioxide substrates.

Development speed enhancers that may be used include, for example, picric acid, nicotinic acid or nitrocinnamic acid at a weight level of up to 20 percent, baed on the combined weight of resin and sensitizer. These enhancers tend to increase the solubility of the photoresist coating in both the exposed and unexposed areas, and thus they are used in applications when speed of development is the overriding consideration even though some degree of contrast may be sacrificed. That is, while the exposed areas of the photoresist coating will be dissolved more quickly by the developer, the speed enhancers will also cause a larger loss of photoresist coating from the unexposed areas. Free radical initiators such as di-(trichloromethyl)stilbenyl triazine and 1,1,1-trichloro-t-butyl acetophenone generate acid functionality upon exposure. They can therefore enhance exposure plus provide free radicals for cross-linking the image when baking afterward.

Non-ionic surfactants that may be used in the solution containing the light-sensitive composition of this invention include, for example, nonylphenoxy poly(oxyethylene)ethanol; octylphenoxy(poly)oxyethylene ethanol; and dinonyl phenoxy poly(oxyethylene) ethanol at up to 10 percent weight levels, based on the combination weight of resin and sensitizer.

The prepared photosensitive solution can be applied to a substrate to form a photoresist by any conventional method used in the photoresist art, including dipping, spraying, whirling and spin coating. When spin coating, for example, the resist solution can be adjusted as to the percentage of solids content in order to provide coating of the desired thickness given the type of spinning equipment utilized and the amount of time allowed for the spinning process.

Examples of substrates that may be used to make photomechanical recording layers such as printing forms for letterpress, offset, screen printing, and gravure as well as relief copies are aluminum plates, which may be anodized, granulated and/or silicatized, zinc plates, steel plates, possibly treated with chromium, as well as plastic film or paper.

The support for preparing the photoresist of this invention may be any suitable support such as a metal which may be electrochemically or mechanically roughened, such as aluminum and its alloys; plastic films such as polyester or polyolefin; wood; paper; semi-condutor materials (i.e., materials which are not conductive unless and until they are doped) such as silicon, gallium arsenide; ceramics; and textiles. Preferably, the support is a silicon-based wafer.

All materials of which capacitors, semiconductors, multilayer printed circuits, or integrated circuits consist or from which they can be made are candidates for substrates. Particular candidates are surfaces of pure silicon and thermally oxidized and/or aluminum-coated silicon materials which may also be doped, including all other substrates usually found in semi-conductor technology such as silicon nitride, gallium arsenide, indium phosphide, tantalum, copper, polysilicon, ceramics and aluminum/copper mixtures. Other possibilities are substrates known from liquid crystal displays such as glass and indium stannic oxide; also metal plates and films made for example of aluminum, copper, or zinc; bimetallic and trimetallic films, also electrically non-conducting metallized films or, if applicable, aluminum-coated $SiO_2$ materials and paper. These substrates may be subjected to heat pretreatment, be surface roughened, etched, or treated with chemicals to improve desired properties, e.g. to increase hydrophilicity.

After the photosensitive composition solution with the o-quinone diazide photosensitizer is coated onto the substrate, the substrate is baked at approximately 80 °C to 100 °C, until substantially all of the solvent has evaporated and only a thin coating of photoresist composition on the order of a micron in thickness remains on the substrate. The coated substrate can then be exposed to actinic radiation especially ultraviolet radiation in the range of 200 nm to 450 nm, produced by use of suitable photomasks, negatives,

stencils, templates, projection means, etc. In a more preferred embodiment the u.v. exposure range is from about 248 nm to about 436 nm.

The recording material according to the invention is irradiated in the pattern of an image. Sources or actinic radiation are: metal halide lamps, carbon arc lamps, xenon lamps and mercury vapor lamps. Irradiation with high-energy radiation such as laser, electron, or x-radiation is preferred. The lasers mentioned are in particular helium/neon lasers, eximer lasers, argon lasers, krypton lasers, and helium/cadmium lasers.

The layer thickness varies depending on its application. It amounts to 0.1 to 100 µm, particularly 0.3 to 10 µm.

The application of the radiation-sensitive mixture to the substrate can be accomplished by spraying, flow coating, rolling, centrifugal coating, and dip coating. After this, the solvent is removed by evaporation so that the radiation-sensitive layer remains behind on the surface of the substrate. The mixture can however, first be applied in the above-mentioned fashion to an intermediate substrate, after which it is transferred to the final substrate material under pressure and at an elevated temperature. Essentially all materials suitable as substrate materials can be used for the intermediate substrate. The layer is then irradiated in the pattern of the image. High-energy radiation such as x-rays or electron radiation are particularly preferred. High-energy Synchrotron radiation with doses of 20 to 200 nJ/cm or radiation of an electron beam recorder is particularly preferred. In the radiation-sensitive layer, an image pattern is then revealed by development by treating the layer with a developer solution which dissolves or removes the irradiated zones of the material.

In each case, the exposed resist-coated substrates are usually developed by immersion in an alkaline developing solution, such as an alkali metal ion, such as potassium- or ammonium-ion based aqueous alkaline solution, including silicates, metasilicates, hydroxides, hydrogen or dihydrogen phosphates, carbonates or hydrogen carbonates, but also by ammonia and the like. In use the developer is agitated, for example, by nitrogen burst agitation. The substrates are allowed to remain in the developer unil all, or substantially all, of the resist coating has dissolved from the exposed areas. The content of these substances in the developer solution generally amounts to 0.1 to 15 wt.%, preferably 0.5 to 5 wt.% based on the weight of the developer solution.

After removal of the coated wafers from the developing solution, a post-development heat treatment or bake may be employed to increase the coating's adhesion and chemical resistance to etching solutions and other substances as taught by GB-A-1,154,749. The post-development heat reatment can comprise the oven baking of the coating and substrate below the coating's softening point. In industrial applications, particularly in the manufacture of microcircuitry units on silicon/silicon dioxide-type substrates, the developed substrates may be treated with a buffered, hydrofluoric acid etching solution. The resist compositions of the present invention are resistant to such etching solutions and provide effective protection for the unexposed resist-coated areas of the substrate.

In the preferred embodiment the developed resist structures based on the radiation-sensitive mixture may be hardened by heating a resist structure on a hot plate up to a point just below the flow temperature and then exposing the entire surface with UV light from a xenon-mercury vapor lamp (range 200 to 250 nm). This hardening cross-links the resist structures so that the structures usually have flow resistance up to a temperature of over 200 °C. Hardening can also be done without high temperatures, merely by irradiating the UV light. This is particularly the case when high-energy light such as electron radiation is used.

It is known in the art that photosensitive compositions based on o-quinone diazide photosensitizer are of positive-working variety. However, this invention is not so limited and is particularly suitable as a so-called image-reveral photoresist where by suitable other ingredients or processing steps which are known in the art a negative image may be obtained. For example, one may include suitable crosslinking agents in the photosensitive composition. Non-exclusive examples of crosslinking agents and processes are hexamethylol melamine ether as taught in US-A- 4,581,321; as well as crosslinking agents and processes taught in US-A-4,104,070; 4,196,003, 4,576,901 and 4,506,006; as well as the dimethylol paracresol and other classes of crosslinkers taught in U.S. Patent Application 06/895,609.

The herein claimed substituted hydroxystyrene and acetoxystyrene polymers may be substituted for the alkali soluble binding resins taught in these references. The crosslinking compound is a compound, which when in the presence of that amount and strength of acid generated when the diazide is exposed, is capable of crosslinking the polymer. This occurs upon the application of sufficient heat to diffuse the acid to the crosslinking component but less heat than will decompose the diazide. The generally preferred class of such compounds are those capable of forming a carbonium ion under the foregoing acid and heat conditions. Crosslinkers particularly suitable for use in the present invention non-exclusively include those having the general formula:

$(R_4O\text{-}CHR_6)_n\text{-}A\text{-}(CHR_7\text{-}OR_5)_m$

wherein

| | |
|---|---|
| A | has the formula B-Y-B, wherein |
| B | is a substituted or unsubstituted mononuclear of fused polynuclear aromatic hydrocarbon or an oxygen or sulfur containing heterocyclic compound, and |
| Y | is a single bond, $(C_1\text{-}C_4)$alkylene or alkylenedioxy, the chains of which may be interrupted by -O-, -S-, $-SO_2-$, -CO-, -CO-O-, -O-CO-O-, -CO-NH-, or phenylenedioxy, |
| $R_4$ and $R_5$ | independently are hydrogen, $(C_1\text{-}C_6)$alkyl, cycloalkyl, substituted or unsubstituted aryl, alkaryl or acyl, |
| $R_6$ und $R_7$ | independently are hydrogen, $(C_1\text{-}C_4)$alkyl or substituted or unsubstituted phenyl, |
| n | ranges from 1 to 3 and |
| m | ranges from 0 to 3, provided that |
| m + n | is greater than 1. |

The crosslinker would preferably be present in the photographic composition in an amount of from 0.5 % to 20 %, more preferably 1 % to 10 % based on the solid components of the photographic composition. In the most preferred embodiment, when image reversal is desired, a 1,2-naphthoquinone-2diazide-4-sulfonyl containing isomer is employed as the photosensitizer. The 4-isomer has been found to generate more acid than the corresponding 5-isomer and hence is more desirable for image reversal techniques. In one image reversal mode, the photosensitive composition is coated upon a suitable substrate as hereinbefore described, and is dried until it is non-tacky, for example by heating at approximately 20° to 100 °C for from 30 seconds to 3 minutes. It is then-exposed to imaging energy of any desired pattern in a manner well known to the skilled artisan. The resist is then subjected to a post exposure baking of from 95° to 160 °C or more preferably 112° to 120 °C, for from 10 seconds to the time necessary to crosslink the resin. This may range from 10 to 90 seconds. After baking one may perform an optional overall flood exposure. The exposed resist is then developed in a suitable developer until substantially all of the non-image areas of the resist have been removed. Suitable developers non-exclusively include aqueous solutions of sodium hydroxide, and tetramethyl ammonium hydroxide as are well known in the art. The developed resist may optionally be heat treated again.

Example 1

5 g (0.03 mol) of 3,5-dimethyl-4-acetoxystyrene in 20 ml of tetrahydrofuran is stirred at room temperature. 0.1 g of azoisobutyronitrile is added and the reaction conducted under nitrogen. The solution is then heated to reflux for 24 hours while under nitrogen. The produced polymer is then isolated by precipitating in water and dried in a vacuum oven. A yield of 4.4 g (88 %) of poly(3,5-dimethyl-4-acetoxystyrene) is produced having a molecular weight of 23,000.

Example 2

20 g of 3,5-dimethyl-4-acetoxystyrene in 300 ml of tetrahydrofuran is added to a 3-neck flask fitted with a reflux condenser, thermometer and nitrogen gas inlet. The solution is stirred under nitrogen for 30 minutes. 0.4 g of azo isobutyronitrile in 50 ml of tetrahydrofuran is added in one portion at room temperature and stirred under nitrogen. The solution is heated to reflux for 24 hours. The polymer is isolated by precipitating into water and dried to yield 17 g (85 %) of poly(3,5-dimethyl-4-acetoxystyrene) having a molecular weight of 16,000.

Example 3

To the polymeric reaction product of example 2 is added tetramethyl ammonium hydroxide (2 ml, 25 % in methanol) while the polymer is stirred in tetrahydrofuran. Methanol is added as needed. The solution is slightly turbid. The solution is refluxed for 36 hours under nitrogen. After isolation, the reaction product is poly(3,5-dimethyl-4-hydroxystyrene).

Example 4

3-Methyl-4-hydroxyacetophenone

10.8 g of o-cresol (0.1 mol) and acetic anhydride (15.3 g, 0.15 mol) are mixed in a 300 $cm^3$ Hastelloy-C autoclave and cooled to -30 °C. 80 g of anhydrous HF (40 mol) is transferred to the autoclave and the autoclave heated at 50 °C for 2 hours. The autoclave is cooled and most of the HF is removed by evaporation. Traces of the remaining HF are neutralized with KOH and the product is extracted with ethyl acetate (2x100 ml). Concentration gives a brown products (15.3 g). Recrystallization affords a pure 3-methyl-4-hydroxyacetophenone.

Example 5

3-Methyl-4-acetoxyacetophenone

25 g of 3-methyl-4-hydroxyacetophenone (0.17 mol), 50 ml of acetic anhydride and 0.5 g of sodium acetate are placed in a 100 ml flask and heated to reflux overnight. Unreacted acetic anhydride and acetic acid are removed via distillation. 3-Methyl-4-acetoxyacetophenone is distilled at 103 °C (133 $N/m^2$ = 1.0 mm Hg) as a colorless liquid which solidifies upon cooling (32.0 g, 97 % yield).

Example 6

1-(3'-Methyl-4'-acetoxyphenyl)ethanol

32 g of 3-methyl-4-acetoxyacetophenone (0.17 mol) is mixed with 5 % Pd/C (catalyst) and 120 ml of absolute ethanol in a stainless steel autoclave. The autoclave is charged with hydrogen at 18.25 bar (250 psig). Hydrogenation is carried out at 40 °C for 5 hours. The catalyst is filtered and the solvent is removed in a rotary evaporator to afford 32,5 g of 1-(3'-methyl-4'-acetoxyphenyl)ethanolas a viscous oil (98 % yield).

Example 7

3-Methyl-4-acetoxystyrene

32,5 g of 1-(3'-methyl-4'-acetoxyphenyl)ethanol (0.17 mol), 0.32 g of $KHSO_4$ and 0.65 g of t-butyl catechol are mixed in a flask. The flask is equipped with a fractional distillation apparatus and attached to a vacuum pump. Dehydration is conducted at 160 °C - 190 °C under vacuum (67-133 $N/m^2$ = 0.5 - 1.0 mm Hg). 21.87 g of 3-methyl-4-acetoxystyrene is distilled at 122 °C (67 $N/m^2$ = 0.5 mm Hg) as a colorless liquid which solidifies upon cooling (74 % yield).

Example 8

Poly(3-methyl-4-acetoxystyrene) by Solution Polymerization

10 g of 3-methyl-4-acetoxystyrene, and 0.4 g of azoisobutyronitrile are dissolved in degassed tetrahydrofuran in a reaction flask and refluxed overnight. A sample is removed and precipitated into water and filtered to yields poly(3-methyl-4-acetoxystyrene).

Example 9

Hydrolysis

3 ml of a 20 % methanol solution of $Me_4NOH$ is added to the foregoing reaction flask and refluxing under nitrogen is continued. Hydrolysis is complete after 18 hours. The polymer is isolated by precipitating into water. The polymer is gummy and placed in a vacuum oven at 50 °C to yield 7 g of poly(3-methyl-4-hydroxystyrene).

Example 10

Copolymerization with Maleic Anhydride

10.83 g of 3-Methyl-4-acetoxystyrene, 6 g of maleic anhydride and 0.43 g of azoisobutyronitrile are mixed with 60 ml of degassed N-methyl pyrrolidone and heated to 70 °C for 15 hours under $N_2$. A portion of the polymer is precipitated into water. The polymer is then filtered and dried.

Example 11

Imidization

6.2 g of cyclohexylamine are added to the foregoing polymer solution, heated to 75 °C for 1 hour and then at 150 °C for 15 hours. The polymer is isolated by precipitating into water and filtering. Complete imidization as determined by $C^{13}$ NMR is noticed.

Example 12

Poly(3,5-dibromo-4-acetoxystyrene) by Solution Polymerization

10 g of 4-acetoxy-3,5-dibromostyrene are dissolved in 40 g of propylene glycol monomethyl ether acetate, treated with azobisisobutyronitrile as the radical initiator, and heated for 3 h at 70 °C in an airtight container through which purified nitrogen is passed. The same amount of azobisisobutyronitrile (AIBN) is then added and heated for 3 h at 80 °C. The polymer is precipitated from a 100 ml 2:1 methanol:water solution, is removed by suction, taken up in THF, and again precipitated with petroleum ether. The yield after drying is 7.7 to 8.7 g of a white powder.

The molecular weight of the polymer is determined by gel permeation chromatography on an "Ultrastyrogel" column (Waters GmbH) which has been precalibrated with monodisperse polystyrene standard. Depending on the amount of radical initiator added, the following values are obtained:

| Quantity AIBN | Molecular Weight (MW) | Non-Uniformity U | Yield |
|---|---|---|---|
| a) 2x0.12 g | 25,300 | 0.88 | 9.4 g |
| b) 2x0.5 g | 21,300 | 0.84 | 9.4 g |
| c) 2x0.75 g | 13,000 | 0.89 | 8.7 g |

Example 13

Poly(3,5-dibromo-4-acetoxystyrene) by Bulk Polymerization

15 g of 4-acetoxy-3,5-dibromostyrene is mixed with 700 mg azobisisobutyronitrile and transferred to an ampule which is evacuated, and sealed under vacuum. Polymerization is carried out for 3 h at 90 °C, after which the initially molten material solidifies again.

The polymer is taken up in THF, re-precipitated twice (from methanol/water and from petroleum ether), and dried under vacuum. The yield is 10.15 g of a white powder. The molecular weight is determined as in Example 12 and is MW = 31,000 with a non-uniformity U = 1.39.

Example 14

Preparation of Poly(3,5-dibromo-4-hydroxystyrene) by Solution Polymerization

10 g of 3,5-dibromo-4-hydroxystyrene are dissolved in 10 g THF, treated with 0.5 g azobisisobutyronitrile (AIBN), and heated at reflux under nitrogen. A sample taken after 4 h gives a viscous substance on precipitation with methanol which still contains a great deal of monomer together with the polymers. After another 0.5 g of AIBN has been added and after an additional reaction time of 6 h, the polymer is precipitated from petroleum ether. The yields after drying amounts to 4.2 g of a white powder with a molecular weight MW of about 3,500.

Example 15

Preparation of Poly(3,5-dibromo-4-hydroxystyrene) by Bulk Polymerization

5 g of 3,5-dibromo-4-hydroxystyrene are bulk polymerized similarly to Example 12, adding 250 mg AIBN. The yield (after precipitatin from petroleum ether) amounts to 3.4 g of a white powder (MW approx. 6,000).

Example 16

Copolymerization of 3,5-Dibromo-4-acetoxystyrene with 3,5-Dibromo-3-hydroxystyrene

10 g of a mixture of 8 parts acetoxy compound and 2 parts hydroxy compound are polymerized a) similarly to Example 12 in solution and b) similarly to Example 5 in bulk and isolated. With a), 7.8 g of a white polymer with a molecular weight MW = 8,400 and with b) 6.2 g of a white polymer with a molecular weight MW = 21,000 are obtained.

Example 17

Copolymerization of 4-Acetoxy-3,5-dibromostyrene with 4-Acetoxystyrene

8.4 g of 4-acetoxy-3,5-dibromostyrene are mixed with 4 g of 4-acetoxystyrene, treated with 600 mg AIBN, and placed in an ampule which is sealed after degassing and evacuation. Polymerization is carried out for 3 h at 90 °C. By a procedure similar to Example 12, 9.4 g of a white polymer (MW approx. 30,700) is obtained with a non-uniformity U = 1,38.

Example 18

Bulk Polymerization of 4-Acetoxy-3-bromo-5-methylstyrene

10 g 4-acetoxy-3-bromo-5-methylstyrene are mixed with AIBN and polymerized similarly to Example 9 in a degased, sealed ampule for 3 h at 90 °C. After processing similar to Example 12, 7.5 g of a white polymer (MW = 30,300) is obtained with a non-uniformity U = 1.28.

Example 19

Poly(3,5-dibromo-4-hydroxystyrene) by Alkaline Hydrolysis of Poly(4-Acetoxy-3,5-dibromostyrene)

7.7 g of the reaction product from preparation example 1 is suspended in 120 ml of water and treated with 7.3 g tetramethylammonium hydroxide pentahydrate. The mixture is heated for 6 hours at 70 °C with nitrogen being passed through then filtered, and 10 ml concd. HCl is added. The mixture then has a pH of 2 and a white precipitate appears which is removed by suction and reprecipitated twice from THF by dripping into water. 5.6 g of a white powder is obtained.

Example 20

Poly(3,5-dibromo-4-hydroxystyrene) by Hydrazinolysis of Poly(4-acetoxy-3,5-dibromostyrene)

9.73 g of the reaction product from Example 4 is dissolved in 50 ml of THF, 25 ml methanol is added, the mixture is treated with 11.67 g hydrazine hydrate (80 % aqueous solution) and stirred for 2.5 h at room temperature. After addition of 20 ml HCl, a clear solution is obtained which is brought to a pH of 2 with concentrated HCl. The polymer is isolated by pouring into 1.5 liter of water, removed by suction, precipitated from THF in water, and dried. The yield amounts to 7.8 g of a white powder.

Example 21

Poly(3,5-dibromo-4-hydroxystyrene) by Acid Hydrolysis of Poly(4-acetoxy-3,5-dibromostyrene)

5 g poly(4-acetoxy-3,5-dibromostyrene) is suspended in 50 ml of a cold saturated solution of hydrochloric acid in methanol. The mixture is stirred for 24 h at room temperature then 100 ml water is added, the polymer is isolated by suction and reprecipitated from THF in water. The yields amounts to 4.8 g of the hydrolyzed polymer.

Example 22

A photoresist is made up of a solution containing 10 % of solids of 2,3,4-trihydroxy-3′-methyl benzophenone 1,2-naphthoquinone-2-diazide-4-sulfonic acid triester and 90 % of solids of the resin produced according to example 3 in sufficient propylene glycol monomethyl ether acetate to form a homogeneous solution. Using this formulation, silicon wafers are coated at 4,000 rpm and then soft-baked in a vented convection oven at 90 °C for 30 minutes. Actinic exposure is applied using the Perkin Elmer 200 Micralign aligner through a glass photomask containing a resolution test pattern. Using aperture #4, the scan speeds are varied between 200 and 400 arbitrary energy units. These different scan speeds (each scan speed represents a different experiment) correspond to between 20 and 10 $mJ/cm^2$ respectively as determined by a radiometer for wave lengths between 365 and 436 nm. The photomask consists of a resolution test pattern where single line and equal lines and spaces are represented. The width of these features varies between 1.0 and 3.0 µm in 0.25 µm increments. After exposure the wafers are optionally hard baked sequentially on a MTI Inc. hot plate at temperatures ranging from 110 °C to 150 °C for up to 60 seconds. A relief image is not observable when the wafers are placed under an optical microscope with monochromatic 520 nm illumination.

After developing the exposed and optionally hard baked wafers in a 0.33 N solution of tetramethylammonium hydroxide in an immersion mode process for 3 minutes with slight agitation, the wafers are DI water rinsed and spin dried. If the wafers are now examined using a scanning electron microscope at 10,000 magnification, 1 µm single space and larger geometries are clearly seen to be completely opened.

Example 23

A photoresist composition is prepared by combining in admixture poly(3-methyl-4-hydroxystyrene) of Example 9 (PMHS), 15 % by weight of the polymer of 2,3,4-trihydroxy-3′-methyl-benzophenone 1,2-naphthoquinone-2-diazide-4-sulfonic acid triester photosensitizer, 5 % by weight of 2,6-dimethylol-p-cresol, and a striation inhibiting agent in a solvent solution of propylene glycol monomethylether acetate. Likewise, a control photoresist is formulated substituting a standard cresol-formaldehyde resin. The PMHS and control resists are spin coated onto silicon wafers treated with an adhesion promoter, baked at 90 °C for 30 minutes in a recirculating oven and exposed to broadband UV light (Oriel) through a quartz Optoline mask. A 60 second post exposure bake at 120 °C on a hotplate is followed by a 2 $mJ/cm^2$ flood exposure on the same instrument. Development is with 0.16 N tetramethylammonium hydroxide for 2 minutes for the test resist and with 0.22 N tetramethylammonium hydroxide for 45 seconds for the control resist. The test resist gives nominal photospeed and contrast values of 27.5 $mJ/cm^2$ and 6.0 respectively. The control resist results are 9.1 $mJ/cm^2$ nd 2.9.

Example 24

The PMHS and control resists of example 23 are spin coated onto silicon wafers treated with an adhesion promoter, baked at 90 °C for 30 minutes in a recirculating oven and exposed to broadband UV light (Oriel) through a quartz Optoline mask. Development of the PMHS resist in a 0.18 N tetramethylammonium hydroxide solution for 60 seconds gives a calculated photo-speed of 300 $mJ/cm^2$ and a contrast of 2.3. Development of the control resist with 0.30 N tetramethylammonium hydroxide gives a photospeed of 100 $mJ/cm^2$ and a contrast of 2.5.

Example 25

A coating solution is prepared from:

4 pw of a cresol-formaldehyde Novolak with a softening range of 105 to 120 °C,

2 pw of an orthocarboxylic acid ester consisting of 2-phenoxyethanol and orthoformic acid according to DE-A-37 30 787, and

4 pw of a poly(3,5-dibromo-4-hydroxystyrene) similar to preparation examples 14 or 15 in

30 pw of propylene glycol methyl ether acetate.

The solution is spun down onto a silicon wafer treated with an adhesion promoter (hexamethyldisilizane) at 3,000 rpm. After drying at 85 °C for 30 min in a circulating air oven, a film thickness of 0.85 microns is obtained. Irradiation in the pattern of the image is carried out by Synchrotron radiation (Bessy, Berlin, air gap 2 mm) at a dose of 30 mJ/$cm^2$ through a gold-on-silicon mask. The experimental setup is found in A. Heuberger, "X-Ray Lithography", Microelectronic Engineering 3, 535-556 (1985). The wafer is developed with an alkaline developer with the following composition:

5.3 pw sodium metasilicate x9$H_2O$

3.4 pw trisodium phosphate x12$H_2O$

0.3 pw sodium dihydrogen phosphate and sufficient completely deionized water to make up a 0.3 N developer solution.

After a developing time of 30 s, an error-free image is obtained with all the details of the mask. The resist edges are negatively undercut and are at an angle of nearly 90 °C (in a scanning electron microscope [SEM] photograph). This does not change when tempering is carried out for 30 min at 140 °C. The film thickness of 0.85 microns also remains constant within the limits of experimental error.

The same occurs when the same measurements are made after four week's storage time at room temperature.

Example 26

A coating solution is prepared from:

4 pw of a cresol-formaldehyde Novolak with a softening range of 105 to 120 °C,

2 pw o an oligomeric acetal of cyclohexanone with triethylene glycol according to DE-A-37 30 787,

4 pw of a poly(3,5-dibromo-4-hydroxystyrene) similar to examples 14 or 15 in

30 pw propylene glycol methyl ether acetate.

The solution is spun down onto a silicon wafer treated with an adhesion promoter (hexamethyldisilizane) at 3,000 rpm. After drying at 85 °C for 30 min in a circulating air oven, a film thickness of 0.85 microns is obtained. Irradiation in the pattern of the image is carried out by Synchrotron radiation (Bessy, Berlin, air gap 2 mm) at a dose of 30 mJ/$cm^2$ through a gold-on-silicon mask. The experimental setup is found in A. Heuberger, "X-Ray Lithography," Microelectronic Engineering 3, 535-556 (1985). The wafer is developed with an alkaline developer with the following composition:

5.3 pw sodium metasilicate x9$H_2O$

3.4 pw trisodium phosphate x12$H_2O$

0.3 pw sodium dihydrogen phosphate, and sufficient completely deionized water to make. up a 0.3 N developer solution.

After a developing time of 30 s, an error-free image is obtained with all the details of the mask. The resist edges are negatively undercut and are at an angle of nearly 90 °C (in a scanning electron microscope [SEM] photograph). This does not change when tempering is carrier out for 30 min at 140 °C. The film thickness of 0.85 microns also remains constant within the limits of experimental error.

The same occurs when the same measurements are made after four week's storage time at room temperature.

Example 27

Comparative Example:

A coating solution is prepared from:

4 pw of a cresol-formaldehyde Novolak with a softening range of 105 to 120 °C,

2 pw of an orthocarboxylic acid ester made from 2-phenoxyethanol and orthoformic acid according to DE-A-37 30 787,

4 pw of a brominated poly(p-hydroxy)styrene with a bromine content of 50 wt.% (commercial product of Maruzen, see DE-A 38 21 585)

in

30 pw of propylene glycol methyl ether acetate.

This is spun down according to Example 25 onto a substrate, dried, irradiated in the pattern of an image, and developed. The image reproduction is good, but removal of the dark areas at 250 microns/min leaves much to be desired. After storage at 40 °C for one week, because of the high rate of removal of dark areas and the high development speed, image differentiation is no longer possible.

Example 28

A coating solution is made from:

2 pw of a silylenol ether of 2 parts cyclopentanone and one part dichloromethyl phenyl silane according to DE-A 37 30 783 and

8 pw of a poly(3-bromo-4-hydroxy-5-methylstyrene) in

30 pw of propylene glycol methyl ether acetate.

This is spun down according to Application Example 25 onto a substrate, and after drying irradiated at a dose of 60 $mJ/cm^2$. Development is carried out in the developer of Application Example 25, but its concentration is set at 0.3 N. After a developing time of 13.5 s, an error-free image corresponding to that of Example 25 is obtained. Only 0.3 microns of the dark area is removed when the initial film thickness is 1.08 microns. The storage stability is also as stated in Example 25.

## Claims

1. Homo- and copolymers of 3-mono- and 3,5-disubstituted 4-acetoxy- and 4 hydroxy-styrenes having a molecular weight in the range of from 1,000 to 800,000, wherein said substituents in the 3- or 3,5-position independently are $(C_1\text{-}C_{10})$alkyl, $(C_1\text{-}C_{10})$alkoxy, primary or secondary amino, halogen (Cl, Br, I), $NO_2$, or $SO_3H$, wherein homo- and copolymers of 4-hydroxy-styrene which is 3-monosubstituted with $(C_1\text{-}C_{10})$alkoxy or which is 3-mono- or 3,5-disubstituted with $(C_1\text{-}C_{10})$alkyl are excluded.

2. Homopolymers according to claim 1, wherein the substituents in the 3- or 3,5-positions independently are $(C_1\text{-}C_{10})$alkyl, in particular methyl, $(C_1\text{-}C_{10})$alkoxy, primary or secondary amino, or halogen.

3. Homo- and copolymers according to claim 1, wherein the substituents in the positions 3 or 3 and 5 are $(C_1\text{-}C_{10})$alkyl or halogen, said homo- and copolymers containing units of the general formula I

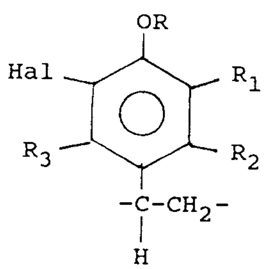

(I)

wherein

| | |
|---|---|
| R | is hydrogen or acetyl, |
| Hal | is chlorine or bromine, |
| $R_1$ | is hydrogen, $(C_1\text{-}C_{10})$alkyl, or halogen; and |
| $R_2$ and $R_3$ | are hydrogen. |

4. Homo- and copolymers according to claim 3, wherein

| | |
|---|---|
| R | is hydrogen, |
| Hal | is bromine and |
| $R_1$ | is $(C_1\text{-}C_3)$alkyl; and |
| $R_2$ and $R_3$ | are hydrogen. |

**5.** Copolymers according to claim 1 or 2, wherein said copolymer is of general formula III

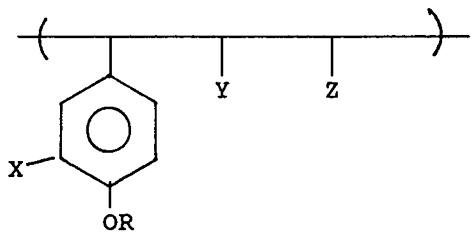

(III)

wherein
R is hydrogen or acetyl, in particular acetyl,
X is ($C_1$-$C_{10}$)alkyl, ($C_1$-$C_{10}$)alkoxy, primary or secondary amino, Br, I, Cl, $NO_2$ or $SO_3H$, and
Y is 4-acetoxy- or 4-hydroxy-styrene, styrene, an acrylate or methacrylate, 3,5-di-X-substituted 4-acetoxy- or 4-hydroxy-styrene, maleic anhydride or N-substituted maleimides wherein the N-substituents are selected from the group consisting of aliphatic, cycloaliphatic and heterocyclic groups and
Z is absent or is selected from 4-acetoxy- or 4-hydroxy-styrene, styrene, an acrylate or methacrylate, 3,5-di-X-substituted 4-acetoxy- or 4-hydroxy-styrene, maleic anhydride or N-substituted maleimides wherein the N-substitution is selected from the group consisting of aliphatic, cycloaliphatic and heterocyclic groups; and wherein said copolymer or terpolymer has an average molecular weight in the range of from 1,000 to 800,000.

**6.** Copolymers according to claim 1 or 2, wherein said copolymer is of general formula IV

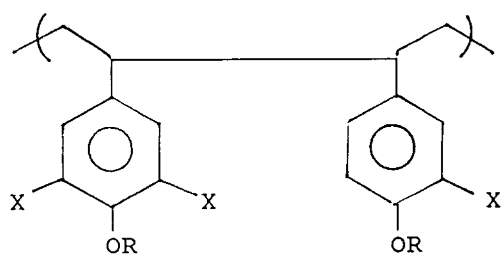

(IV)

wherein
R is hydrogen or acetyl, in particular hydrogen; and
X is independently ($C_1$-$C_{10}$)alkyl, Br, I, Cl, $NO_2$ or $SO_3H$; and
wherein the copolymer has an average molecular weight in the range of from 1,000 to 800,000.

**7.** Copolymers according to claim 3 or 4, wherein the copolymer comprises at least 10 % of units of general formula I.

**8.** Photosensitive composition which comprises as a light-sensitive compound an o-quinonediazide, a solvent and a binder, wherein said binder is a homopolymer according to claim 1 or 2 or a copolymer according to claim 5 or 6.

**9.** Photosensitive composition according to claim 8, wherein the light-sensitive compound is a condensation product of a 1,2-naphthoquinone-2-diazide-4-or 5-sulfonyl compound with a hydroxybenzophenone.

**10.** Photosensitive composition according to claim 8 or 9, wherein the ratio by weight of said homo- or copolymer to said light-sensitive compound is in the range of from 1:1 to 20:1.

**11.** Photosensitive composition according to claims 8 to 10, wherein the composition further comprises a crosslinker of the general formula

$(R_4O\text{-}CHR_6)_n\text{-}A\text{-}(CHR_7\text{-}OR_5)_m$

wherein

| | |
|---|---|
| A | has the formula B-Y-B, wherein |
| B | is a substituted or unsubstituted mononuclear or fused polynuclear aromatic hydrocarbon or an oxygen or sulfur containing heterocyclic compound, and |
| Y | is a single bond, $(C_1\text{-}C_4)$alkylene or alkylenedioxy, the chains of which may be interrupted by -O-, -S-, $-SO_2-$, -CO-, -CO-O-, -O-CO-O-, -CO-NH-, or phenylenedioxy, |
| $R_4$ and $R_5$ | independently are hydrogen, $(C_1\text{-}C_6)$alkyl, cycloalkyl, substituted or unsubstituted aryl, alkaryl or acyl, |
| $R_6$ und $R_7$ | independently are hydrogen, $(C_1\text{-}C_4)$alkyl or substituted or unsubstituted phenyl, |
| n | ranges from 1 to 3 and |
| m | ranges from 0 to 3, provided that |
| m + n | is greater than 1. |

**12.** A positive-working radiation-sensitive composition which comprises a radiation-sensitive compound forming an acid as well as a compound cleavable by acid, wherein the acid-forming compound is a homo- or copolymer according to claim 3, 4 or 7.

**13.** Radiation-sensitive composition according to claim 12, wherein the acid-forming compound is present in a percentage of from 5 to 60 %, based on the weight of the composition.

**14.** Radiation-sensitive composition according to claim 12 or 13, additionally comprising a binder which is insoluble in water but soluble, at least swellable in aqueous alkaline solutions and organic solvents.

**15.** Radiation-sensitive composition according to claims 12 to 14, wherein the acid-forming compound and the binder in the composition are in approximately equal proportions by weight.

**16.** Recording material comprising a photosensitive- or radiation-sensitive composition and a support, wherein said composition is a dried photosensitive composition according to claims 8 to 11 or a dried radiation-sensitive composition according to claims 12 to 15.

**Patentansprüche**

**1.** Homo- und Copolymere von 3-mono- und 3,5-disubstituierten 4-Acetoxy- und 4-Hydroxystyrolen mit einem Molekulargewicht im Bereich von 1.000 bis 800.000, worin diese Substituenten in 3- oder 3,5-Stellung unabhängig voneinander $(C_1\text{-}C_{10})$-Alkyl, $(C_1\text{-}C_{10})$-Alkoxy, primäres oder sekundäres Amino, Halogen (Cl, Br, J), $NO_2$ oder $SO_3H$ sind, wobei mit $(C_1\text{-}C_{10})$-Alkoxy 3-monosubstituierte oder mit $(C_1\text{-}C_{10})$ -Alkyl 3-mono- oder 3,5-disubstituierte Homo- und Copolymere des 4-Hydroxystyrols ausgeschlossen sind.

**2.** Homopolymere nach Anspruch 1, worin die Substituenten in 3- oder 3,5-Stellung unabhängig voneinander $(C_1\text{-}C_{10})$-Alkyl, insbesondere Methyl, $(C_1\text{-}C_{10})$-Alkoxy, primäres oder sekundäres Amino oder Halogen sind.

**3.** Homo- und Copolymere nach Anspruch 1, worin die Substituenten in 3- oder 3,5-Stellung $(C_1\text{-}C_{10})$-Alkyloder Halogen sind, wobei diese Homo- und Copolymere Einheiten der allgemeinen Formel I

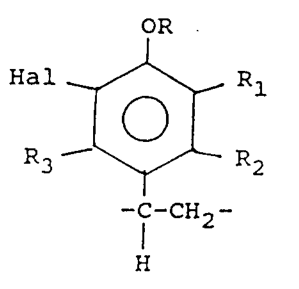

(I)

enthalten, worin

R Wasserstoff oder Acetyl,
Hal Chlor oder Brom,
$R_1$ Wasserstoff, $(C_1-C_{10})$-Alkyl oder Halogen und
$R_2$ und $R_3$ Wasserstoff bedeuten.

4. Homo- und Copolymere nach Anspruch 3, worin

R Wasserstoff,
Hal Brom,
$R_1$ $(C_1-C_3)$-Alkyl sowie
$R_2$ und $R_3$ Wasserstoff bedeuten.

5. Copolymere nach Anspruch 1 oder 2, worin dieses Copolymer der allgemeinen Formel III

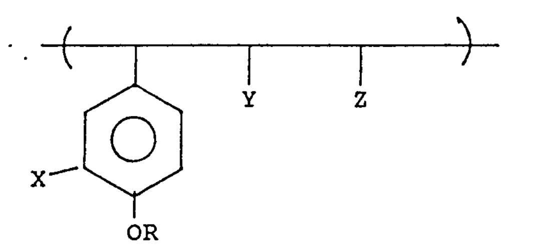

(III)

entspricht, worin

R Wasserstoff oder Acetyl, insbesondere Acetyl,
X $(C_1-C_{10})$ -Alkyl, $(C_1-C_{10})$-Alkoxy, primäres oder sekundäres Amino, Br, J, Cl, $NO_2$ oder $SO_3H$ und
Y 4-Acetoxy- oder 4-Hydroxystyrol, Styrol, ein Acrylat oder Methacrylat, 3,5-di-X-substituiertes 4-Acetoxy- oder 4-Hydroxystyrol, Maleinsäureanhydrid oder N-substituierte Maleinimide bedeuten, wobei die N-Substituenten aliphatische, cycloaliphatische und/oder heterocyclische Gruppen sind, und
Z fehlt oder unter 4-Acetoxy- oder 4-Hydroxystyrol, Styrol, einem Acrylat oder Methacrylat, 3,5-di-X-substituiertem 4-Acetoxy- oder 4-Hydroxystyrol, Maleinsäureanhydrid oder N-substituierten Maleinimiden ausgewählt ist, wobei die N-Substituenten aliphatische, cycloaliphatische und/oder heterocyclische Gruppen sind und wobei dieses Copolymer oder Terpolymer ein durchschnittliches Molekulargewicht im Bereich von 1.000 bis 800.000 besitzt.

6. Copolymere nach Anspruch 1 oder 2, worin dieses Copolymer der allgemeinen Formel IV

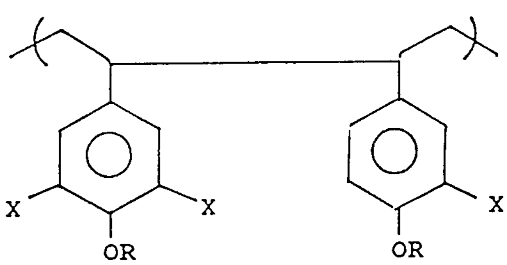

(IV)

entspricht, worin

R Wasserstoff oder Acetyl, insbesondere Wasserstoff, und
X unabhängig voneinander $(C_1-C_{10})$-Alkyl, Br, J, Cl, $NO_2$ oder $SO_3H$ bedeuten, und

wobei das Copolymer ein durchschnittliches Molekulargewicht im Bereich von 1.000 bis 800.000 besitzt.

7. Copolymere nach Anspruch 3 oder 4, worin das Copolymer mindestens 10% Einheiten der allgemeinen Formel I enthält.

8. Lichtempfindliches Gemisch, das ein o-Chinondiazid als lichtempfindliche Verbindung, ein Lösungsmittel und ein Bindemittel enthält, wobei dieses Bindemittel ein Homopolymer nach Anspruch 1 oder 2 oder ein Copolymer nach Anspruch 5 oder 6 ist.

9. Lichtempfindliches Gemisch nach Anspruch 8, worin die lichtempfindliche Verbindung ein Kondensationsprodukt aus einer 1,2-Naphthochinon-2-diazid-4- oder -5-sulfonylverbindung mit einem Hydroxybenzophenon ist.

10. Lichtempfindliches Gemisch nach Anspruch 8 oder 9, worin das Gewichtsverhältnis des Homo- oder Copolymers zur lichtempfindlichen Verbindung im Bereich von 1:1 bis 20:1 liegt.

11. Lichtempfindliches Gemisch nach einem der Ansprüche 8 bis 10, worin das Gemisch ferner ein Vernetzungsmittel der allgemeinen Formel

$$(R_4O\text{-}CHR_6)_n\text{-}A\text{-}(CHR_7\text{-}OR_5)_m$$

enthält, worin

| | |
|---|---|
| A | der Formel B-Y-B entspricht, worin |
| B | für einen gegebenenfalls substituierten einkernigen oder kondensierten mehrkernigen aromatischen Kohlenwasserstoff oder eine sauerstoff- oder schwefelhaltige heterocyclische Verbindung und |
| Y | für eine einfache Bindung, $(C_1\text{-}C_4)$-Alkylen oder -Alkylendioxy, deren Ketten durch -O-, -S-, $-SO_2-$, -CO-, -CO-O-, -O-CO-O-oder -CO-NH- unterbrochen sein können, oder Phenylendioxy stehen, |
| $R_4$ und $R_5$ | unabhängig voneinander Wasserstoff, $(C_1\text{-}C_6)$-Alkyl, Cycloalkyl, gegebenenfalls substituiertes Aryl, Alkaryl oder Acyl und |
| $R_6$ und $R_7$ | unabhängig voneinander Wasserstoff, $(C_1\text{-}C_4)$-Alkyl oder gegebenenfalls substituiertes Phenyl bedeuten, |
| n | im Bereich von 1 bis 3 und |
| m | im Bereich von 0 bis 3 liegen, mit der Maßgabe, daß |
| m + n | größer als 1 ist. |

12. Positiv arbeitendes, strahlungsempfindliches Gemisch, das eine strahlungsempfindliche, säurebildende sowie eine säurespaltbare Verbindung enthält, worin die säurebildende Verbindung ein Homo- oder Copolymer nach einem der Ansprüche 3, 4 oder 7 ist.

13. Strahlungempfindliches Gemisch nach Anspruch 12, worin die säurebildende Verbindung mit einem Prozentgehalt von 5 bis 60%, bezogen auf das Gewicht des Gemisches, vorliegt.

14. Strahlungsempfindliches Gemisch nach Anspruch 12 oder 13, das zusätzlich ein Bindemittel enthält, das in Wasser unlöslich, aber in wäßrigen alkalischen Lösungen und organischen Lösungsmitteln löslich oder zumindest quellbar ist.

15. Strahlungsempfindliches Gemisch nach einem der Ansprüche 12 bis 14, worin die säurebildende Verbindung und das Bindemittel im Gemisch in ungefähr gleichen Gewichtsanteilen vorliegen.

16. Aufzeichnungsmaterial, bestehend aus einem Träger und einer licht- oder strahlungsempfindlichen Schicht, worin die Schicht aus dem getrockneten lichtempfindlichen Gemisch nach einem der Ansprüche 8 bis 11 oder dem getrockneten strahlungsempfindlichen Gemisch nach einem der Ansprüche 12 bis 15 besteht.

## Revendications

1. Homo- et copolymères de 4-acétoxy- et 4-hydroxy-styrènes 3- mono- et 3,5-disubstitués, ayant un poids moléculaire dans la gamme de 1.000 à 800.000, dans lesquels lesdits substituants en position 3

et 3,5 représentent indépendamment $C_1$-$C_{10}$ alkyle, $C_1$-$C_{10}$ alkoxy, amino primaire ou secondaire, halogéno (Cl, Br, I),$NO_2$, ou $SO_3H$, les homo- et copolymères de 4-hydroxy-styrène qui est monosubstitué en 3 avec ($C_1$-$C_{10}$) alkoxy ou qui est 3-mono ou 3,5-disubstitué avec ($C_1$-$C_{10}$) alkyle étant exclus.

**2.** Homopolymères selon la revendication 1, dans lesquels les substituants en position 3-et 3,5-représentent indépendamment ($C_1$-$C_{10}$) alkyle, en particulier méthyle, ($C_1$-$C_{10}$) alkoxy, amino primaire ou secondaire ou halogéno.

**3.** Homo- et copolymères selon la revendication 1, dans lesquels les substituants en position 3 ou 3 et 5 sont ($C_1$-$C_{10}$) alkyle ou halogéno, lesdits homo- et copolymères contenant des motifs de formule générale I

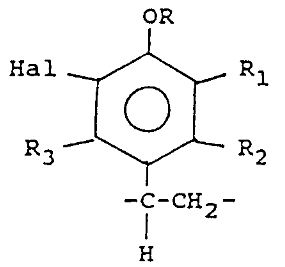

(I)

dans laquelle

| | |
|---|---|
| R | représente l'hydrogène ou acétyle, |
| Hal | représente le chlore ou le brome, |
| $R_1$ | représente l'hydrogène, ($C_1$-$C_{10}$) alkyle ou halogèno ; |
| $R_2$ et $R_3$ | représentent l'hydrogène. |

**4.** Homo-et copolymères suivant la revendication 3, dans lesquels

| | |
|---|---|
| R | représente l'hydrogène, |
| Hal | représente le brome et |
| $R_1$ | représente ($C_1$-$C_3$) alkyle ; et |
| $R_2$ et $R_3$ | représentent l'hydrogène. |

**5.** Copolymères selon la revendication 1 ou 2, dans lesquelles ledit copolymère est de formule générale III

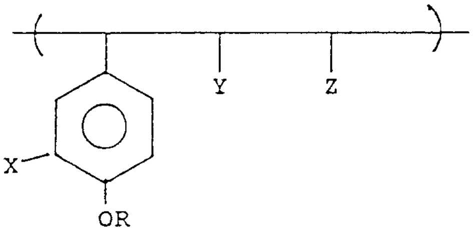

(III)

dans laquelle

R représente l'hydrogène ou acétyle, en particulier acétyle,

X représente ($C_1$-$C_{10}$) alkyle, ($C_1$-$C_{10}$) alkoxy, amino primaire ou secondaire, Br, I, Cl, $NO_2$ ou $SO_3H$, et

Y représente 4-acétoxy- ou 4-hydroxy-styrène, styrène, un acrylate ou méthacrylate, un 4-acétoxy ou 4-hydroxy-styrène-3,5-di-X-substitué,l'anhydride maléique ou des maléimides N-substitués dans lesquels les N-substituants sont choisis parmi les groupes aliphatiques, cycloaliphatiques et hétérocycliques et

Z est absent ou est choisi parmi 4-acétoxy- ou 4-hydroxy-styrène, styrène, un acrylate ou méthacrylate, 4-acétoxy- ou 4-hydroxy-styrène

3,5-di-X-substitué, l'anydride maléique ou des maléimides N-substitués dans lesquels les N-substituants sont choisis parmi les groupes aliphatiques, cycloaliphatiques et hétérocycliques ; et dans lesquels ledit copolymère ou terpolymère possède un poids moléculaire moyen dans la gamme de 1.000 à 800.000.

**6.** Copolymères selon la revendication 1 ou 2, dans lesquels ledit copolymère est de formule générale IV

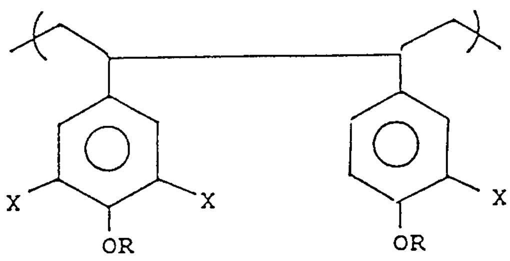

(IV)

dans laquelle

R représente hydrogène ou acétyle, en particulier hydrogène ; et

X est indépendamment ($C_1$-$C_{10}$) alkyle, Br, I, Cl, $NO_2$ ou $SO_3H$ ; et dans lesquels le copolymère a un poids moléculaire moyen dans la gamme de 1.000 à 800.000.

**7.** Copolymères selon la revendication 3 ou 4, dans lesquels le copolymère comprend au moins 10% de motifs de formule générale I.

**8.** Composition photosensible qui comprend en tant que composé sensible à la lumière un o-quinonediazide, un solvant et un liant, dans laquelle ledit liant est un homopolymère selon la revendication 1 ou 2 ou un copolymère selon la revendication 5 ou 6.

**9.** Composition photosensible selon la revendication 8, dans laquelle le composé sensible à la lumière est un produit de condensation d'un 1,2-naphthoquinone-2-diazide-4- ou 5-sulfonyle avec une hydroxybenzophénone.

**10.** Composition photosensible selon la revendication 8 ou 9, dans laquelle le rapport en poids dudit homo- ou co-polymère au dit composé sensible à la lumière se situe dans la gamme de 1:1 à 20:1.

**11.** Composition photosensible selon l'une des revendications 8 à 10, dans laquelle la composition comprend en outre un agent réticulant de formule générale

$(R_4O\text{-}CHR_6)_n\text{-}A\text{-}(CHR_7\text{-}OR_5)_m$

dans laquelle

| | |
|---|---|
| A | possède la formule B-Y-B, dans laquelle |
| B | est un hydrocarbure aromatique à un cycle ou plusieurs cycles fusionnés, substitué(s) ou non substitué(s) ou un hétérocycle contenant de l'oxygène ou du soufre, et |
| Y | représente une liaison simple, ($C_1$-$C_4$) alkylène ou alkylènedioxy, dont les chaînes peuvent être interrompues par -O-, -S-, -$SO_2$-, -CO-, -CO-O-, -O-CO-O-, -CO-NH-, ou phénylène-dioxy, |
| $R_4$ et $R_5$ | représentent indépendamment hydrogène, ($C_1$-$C_6$) alkyle, cycloalkyle, aryle substitué ou non substitué, alkaryle ou acyle, |
| $R_6$ et $R_7$ | représentent indépendamment l'hydrogène, ($C_1$-$C_4$) alkyle ou phényle substitué ou non substitué, |
| n | prend les valeurs de 1 à 3 et |
| m | prend les valeurs de 0 à 3, sous réserve que |
| m + n | soit supérieur à 1. |

**12.** Composition sensible au rayonnement travaillant en positif qui comprend un composé sensible au rayonnement formant un acide ainsi qu'un composé clivable par un acide, dans laquelle le composé formant un acide est un homo- ou copolymère selon la revendication 3, 4 ou 7.

**13.** Composition sensible au rayonnement selon la revendication 12, dans laquelle le composé formant un acide est présent en un pourcentage de 5 à 60%, rapporté au poids de la composition.

**14.** Composition sensible au rayonnement selon la revendication 12 ou 13, comprenant en outre un liant qui est insoluble dans l'eau mais soluble et au moins gonflable dans des solutions aqueuses alkalines et les solvants organiques.

**15.** Composition sensible au rayonnement selon les revendications 12 à 14, dans laquelle le composé formant un acide et le liant de la composition sont présents en quantités approximativement égales en poids.

**16.** Matériau d'enregistrement comprenant une composition photosensible ou sensible au rayonnement et un support, dans laquelle ladite composition est une composition photosensible séchée selon l'une quelconque des revendications 8 à 11 ou une composition sensible au rayonnement séchée selon l'une quelconque des revendications 12 à 15.